Europäisches Patentamt

European Patent Office

Office européen des brevets

(11) Veröffentlichungsnummer: **0 119 388**
**A2**

(12) # EUROPÄISCHE PATENTANMELDUNG

(21) Anmeldenummer: **84100245.4**

(22) Anmeldetag: **11.01.84**

(51) Int. Cl.³: **G 11 C 19/00**

(30) Priorität: **24.01.83 DE 3302248**

(43) Veröffentlichungstag der Anmeldung: **26.09.84**
**Patentblatt 84/39**

(84) Benannte Vertragsstaaten: **AT DE FR GB IT SE**

(71) Anmelder: **Siemens Aktiengesellschaft, Berlin und München Wittelsbacherplatz 2, D-8000 München 2 (DE)**

(72) Erfinder: **Barré, Claude, Dipl.-Ing., Implerstrasse 23, D-8000 München 70 (DE)**

(54) **Schieberegister.**

(57) Zur Erhöhung der Packungsdichte von Schieberegistern in integrierter Ausführung werden als Schaltstufen erfindungsgemäß bipolare Speicherzellen eingesetzt. Für jede Bitstelle ist ein durch Taktimpulse einer ersten und zweiten Taktphase gesteuertes Speicherzellenpaar erforderlich. Da bei normalen, in RAM-Speichern eingesetzten Speicherzellen die gleichen Anschlußpunkte als Eingang und als Ausgang benutzt werden, sind zusätzliche, richtungsabhängige Übertragungsglieder erforderlich, die Rückwirkungen der an den Ausgängen anliegenden Potentiale auf den Schaltzustand der in Übertragungsrichtung jeweils vorhergehenden Speicherzelle verhindern.

SIEMENS AKTIENGESELLSCHAFT       Unser Zeichen
Berlin und München               VPA   83 P 1019 E

Schieberegister

Die Erfindung bezieht sich auf ein Schieberegister nach dem Oberbegriff des Patentanspruchs 1.

Bekannte bipolare Schieberegister sind mit taktflankengesteuerten Flipflops (vergleiche TTL Data Book for Design Engineers, Texas Instruments, Ausgabe 1977, Seite 7-87) oder mit Master-Slave-Flipflops (vergleiche R.G. Hibberd, Integrated Circuit Pocket Book, zweite Auflage 1976, Seiten 200 bis 202) aufgebaut.

Solche Schieberegister benötigen jedoch in integrierter Ausführung verhältnismäßig viel Platz, beispielsweise für jede Schaltstufe ca. 0,05 $mm^2$ in ECL-Technologie.

Der Erfindung liegt die Aufgabe zugrunde, den Platzbedarf je Schaltstufe zu verringern und damit die Packungsdichte insgesamt zu erhöhen. Ausgehend von einem mehrstufigen Schieberegister wird diese Aufgabe durch die Merkmale im kennzeichnenden Teil des Patentanspruchs 1 gelöst. Spezielle Ausführungen sind den Unteransprüchen zu entnehmen.

Zwar werden bei der erfindungsgemäßen Verwendung von Speicherzellen zum Aufbau eines Schieberegister zwei Speicherzellen je Bit benötigt, doch reduziert sich der Flächenbedarf je Bit bei Herstellung in einer auch dem obenangegebenen Beispiel zugrundegelegten Technologie auf ca. 0,02 $mm^2$.

Im folgenden wird die Erfindung anhand von Ausführungsbeispielen, die in der Zeichnung dargestellt sind, näher be-

The 1 Fdl/ 7. 1. 1983

0119388

VPA
83 P 1019 E

schrieben. Es zeigt darin

Fig. 1 einen Abschnitt einer Schiebekatte mit Speicherzellen aus über Kreuz gekoppelten Doppelemittertransistoren,

Fig. 2 einen Daten-Eingangswandler,

Fig. 3 einen Daten-Ausgangswandler,

Fig. 4 ein erstes Ausführungsbeispiel einer Speicherzelle mit invers betriebenen Transistoren und

Fig. 5 ein weiteres Ausführungsbeispiel einer Speicherzelle mit invers betriebenen Transistoren.

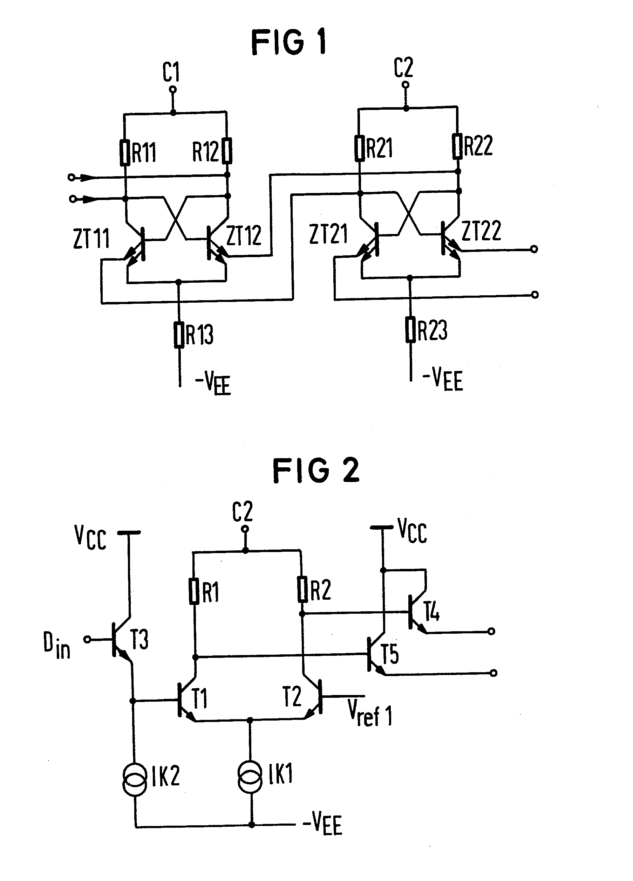

Speicherzellen der gemäß Fig. 1 zum Aufbau der Schiebekette eines Schieberegisters verwendeten Art sind im Prinzip durch die US-PS 2 537 078 bekannt. Zu beachten ist allerdings, daß die bekannten Speicherzellen nicht unverändert für Schieberegister geeignet sind, weil bei ihnen die gleichen Anschlußpunkte als Eingang und als Ausgang benützt werden.

Die aus Fig. 1 ersichtliche Trennung der Dateneingänge und Datenausgänge allein genügt noch nicht für den Einsatz der Speicherzelle in einem Schieberegister, da während des Schreibens die Ausgangspegel den Eingangspegeln folgen. Es müssen daher für jedes zu verschiebende Datenbit zwei Speicherzellen vorhanden sein, die abwechselnd durch verschiedene, sich nicht überlappende Taktimpulse aktiviert werden.

Jede der beiden Speicherzellen in dem in Fig. 1 dargestellten Abschnitt der Schiebekette eines Schieberegisters besteht aus zwei Doppelemittertransistoren ZT11, ZT12, bei denen jeweils der Kollektor des einen Transistors mit der Basis des anderen verbunden ist. Die Kollektoren sind über Kollektorwiderstände R11, R12 an einen Koppelpunkt zur Einspeisung der Taktimpulse einer ersten Taktphase C1 angeschlossen. An dem entsprechenden Koppelpunkt der folgenden Speicherzelle liegen Taktimpulse einer zweiten Taktphase C2. Die Taktimpulse der ersten und zweiten Taktphase können zueinander komplementär oder voneinander
unabhängig sein. Sie dürfen sich, wie schon erwähnt wurde,
jedenfalls nicht überschneiden.

Die ersten Emitter der Doppelemittertransistoren ZT11,
ZT12 sind über einen Widerstand R13 zur Nachbildung einer
Konstantstromquelle mit dem negativen Anschluß $-V_{EE}$
einer Betriebsspannung verbunden. Die zweiten Emitter
sind zur Weiterleitung der in der ersten Speicherzelle
gespeicherten Information an die nächste, identisch ausgebildete Speicherzelle mit den Kollektoren der Transistoren
ZT21, ZT22 dieser Speicherzelle verbunden. Die Informationsübergabe erfolgt jedoch nur, wenn für die Pegel an den
Koppelpunkten zur Einspeisung der Taktimpulse gilt C1 = H
und C2 = L. Entsprechend wird der Inhalt der zweiten
Speicherzelle eines ersten Speicherzellenpaares mit C2 = H
und C1 = L in die erste Speicherzelle eines nächsten
Speicherzellenpaares weitergegeben.

Da die Daten am Anfang einer im allgemeinen vielstufigen
Schiebekette in komplementärer Form benötigt werden, in
der sie gewöhnlich nicht zur Verfügung stehen und weil
verhindert werden muß, daß während der Datenübergabe von
der ersten in die zweite Speicherzelle das in der ersten
Speicherzelle gespeicherte Datenbit überschrieben wird,
ist ein Daten-Eingangswandler notwendig, der die genannten
Bedingungen erfüllt. Ein solcher Daten- Eingangswandler
ist in Fig. 2 dargestellt.

Der Daten- Eingangswandler enthält einen Differenzverstärker mit den Transistoren T1 und T2, deren Emitter
miteinander verbunden und an einer Konstantstromquelle
IK1 angeschlossen sind. Die Basis des einen Transistors
T2 liegt an einem festen Referenzpotential $V_{ref1}$. Dem
Steuereingang des Differenzverstärkers ist ein Emitterfolger mit dem Transistor T3 und einer Konstantstromquelle IK2 vorgeschaltet. Der Emitterfolger empfängt die Dateneingangssignale $D_{in}$. Zwischen den Kollektoren der Transistoren T1, T2 und den zugehörigen Kollektorlastwiderständen R1, R2 sind weitere Emitterfolger mit den Transistoren T4, T5 angeschlossen, welche die Steuersignale für die erste Speicherzelle der Schiebekette liefern. Zu diesem Zweck sind die Emitter der Transistoren T4, T5 des Daten- Eingangswandlers nach Fig. 2 mit den Kollektoren der Transistoren ZT11, ZT12 der ersten Speicherzelle (Fig. 1) verbunden.

Abweichend von der konventionellen Ausbildung entsprechender Schaltungsanordnungen sind die Kollektorlastwiderstände R1, R2 im Eingangwandler nach Fig. 2 nicht mit dem Bezugspotential $V_{CC}$, sondern analog zu der Ausbildung der Speicherzellen mit dem Koppelpunkt zur Eingabe von Taktimpulsen C2 der zweiten Taktphase angeschlossen. Damit kann eine Übergabe des am Eingang $D_{in}$ anliegenden Binärwerts in die erste Speicherzelle nur für C2 = H und C1 = L erfolgen. Für C2 = L wird, unabhängig vom Binärwert des Taktes C1, die Übergabe verhindert.

Zur Erzeugung der Taktimpulse C1, C2 der ersten und zweiten Taktphase kann als Taktwandler eine nicht dargestellte Schaltungsanordnung benützt werden, die dem Eingangswandler weitgehend entspricht, bei der jedoch die Kollektorwiderstände an das Bezugspotential VCC angeschlossen sind. (ECL-Inverter). Es gilt dann C2 = $\overline{C1}$.

Stehen zwei externe Takte zur Verfügung, dann sind auch zwei Taktwandler erforderlich, die aber abweichend von dem vorher genannten Taktwandler jeweils nur einen Ausgangsemitterfolger aufweisen. Je ein nicht benötigter Kollektorwiderstand kann ebenfalls entfallen und durch einen Kurzschluß ersetzt werden.

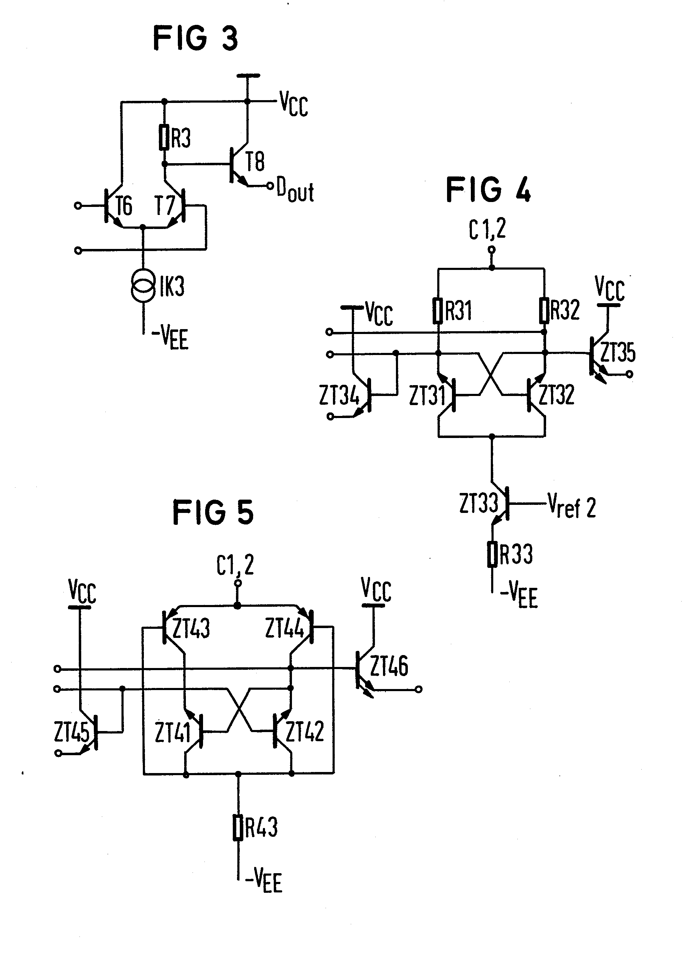

Die Ausgangssignale des Schieberegisters mit Speicherzellen nach Fig. 1 können an sich an den freien Emittern
der über Kreuz gekoppelten Transistoren der letzten
Speicherzelle in komplementärer Form abgenommen werden.
Zu beachten ist dabei, daß die Ausgangsbelastung nur
gering sein darf, um die ordnungsgemäße Funktion dieser
Speicherzelle nicht zu stören. Es ist daher günstiger,
einen Daten- Ausgangswandler nach Fig. 3 in Form eines
Differenzverstärkers mit emittergekoppelten Transistoren
T6, T7 einzusetzen, der durch einen von einer Konstantstromquelle IK3 gelieferten Strom gespeist wird. Die
beiden (Gegentakt-) Eingänge des Differenzverstärkers
sind mit den freien Emittern der Transistoren der letzten
Speicherzelle verbunden. Am Kollektor des mit einem
Kollektorwiderstand R3 versehenen Transistors T7 ist die
Basis eines als Emitterfolger betriebenen Transistors
T8 angeschlossen. An dem vergleichsweise hoch belastbaren Ausgang $D_{out}$ des Daten- Ausgangswandlers stehen
die Ausgangssignale des Schieberegisters in der bei ECL-
Schaltungen üblichen Pegellage zur Verfügung.

Die Verwendung konventioneller Speicherzellen zum Aufbau
von Schieberegistern ist nicht auf Ausführungen nach
Fig. 1 beschränkt. So können beispielsweise die gemeinsamen Emitterwiderstände R13 bzw. R23 für die über Kreuz
gekoppelten Transistoren ZT11 und ZT12 bzw. ZT21 und
ZT22 in an sich bekannter Weise durch Transistoren in
Stromquellenschaltung ersetzt werden. Ferner ist es
möglich, anstelle der zweiten Emitter der Transistoren
ZT11 bis ZT22 zusätzliche Transistoren in Emitterfolgerschaltung als Übertragungsglieder vorzusehen, deren
Basiselektroden mit den Kollektoren der über Kreuz gekoppelten Transistoren ZT11 bis ZT22 verbunden sind. Wird
wenigstens einer der beiden einer Speicherzellen zugeordneten Emitterfolgertransistoren mit zwei Emittern ausgestattet, dann können über die zweiten Emitter die im Schieberegister gespeicherten Daten parallel mit ausreichender Belastungsfähigkeit ausgegeben werden.

Eine der eben beschriebenen Speicherzelle ähnliche Speicherzelle ist in Fig. 4 dargestellt. Ein wichtiger Unterschied besteht jedoch darin, daß bei dem Ausführungsbeispiel nach Fig. 4 die über Kreuz gekoppelten Transistoren ZT31 und ZT32 invers betrieben werden. Diese Betriebsweise bietet die Möglichkeit einer besonders platzsparenden Integration, weil die Transistoren ZT31 und ZT32 sowie der gemäß Fig. 4 vorgesehene, durch ein Referenzpotential $V_{ref2}$ gesteuerte Stromquellentransistor ZT34 in einer gemeinsamen Isolierwanne untergebracht werden können. Die Emitterfolgertransistoren ZT 34, ZT35 sind normal geschaltet.

Ein weiteres Ausführungsbeispiel einer Speicherzelle, deren über Kreuz gekoppelte Transistoren ZT41, ZT42 gleichfalls invers betrieben werden, zeigt die Fig. 5. Hier sind die bei den vorher behandelten Ausführungsbeispielen vorgesehenen Ohmschen Kollektorlastwiderstände für die über Kreuz gekoppelten Transistoren durch pnp-Transistoren ZT43, ZT44 ersetzt. Die Emitter dieser Transistoren sind an den Koppelpunkt zur Einspeisung der Takte C1 bzw. C2 angeschlossen. Die Basiselektroden sind mit den Kollektoren der Transistoren ZT41 und ZT42 verbunden. Als Übertragungsglieder zur Weiterleitung des gespeicherten Zelleninhalts zur anschließenden Zelle dienen die Transistoren ZT45 und ZT46. Der Widerstand R43 zur Erzeugung eines wenigstens annähernd konstanten Speisestroms kann wieder durch einen Transistor in Stromquellenschaltung ersetzt werden. Die Transistoren ZT43, ZT44 können als laterale Transistoren ausgebildet sein.

5 FIGUREN

5 Patentansprüche

0119388

VPA 83 P 1019 E

Patentansprüche

1. Schieberegister zum Verschieben von Datenbits, mit einer Mehrzahl von durch einen Schiebetakt gesteuerten Schaltstufen, die bezüglich des Datenflusses in Serie geschaltet sind, d a d u r c h   g e k e n n z e i c h n e t,
daß als Schaltstufen an sich bekannte Speicherzellen vorgesehen sind, mit je zwei emittergekoppelten bipolaren Transistoren (ZT11, ZT12, ZT21, ZT22, ZT31, ZT32, ZT41, ZT42), bei denen jeweils der Kollektor des einen mit der Basis des anderen Transistors verbunden ist und mit Lastwiderständen (R11, R12, R21, R22, R31, R32, ZT43, ZT44), deren kollektorferne Anschlüsse einen gemeinsamen Koppelpunkt bilden,
daß die über Kreuz gekoppelten Transistoren (ZT11, ZT12, ZT21, ZT22, ZT31, ZT32, ZT41,. ZT42) einer Speicherzelle über richtungsabhängige Übertragungsglieder mit den Kollektoren der entsprechenden Transistoren der jeweils folgenden Speicherzelle verbunden sind und
daß an den Koppelpunkten der ersten, dritten, usw. Speicherzelle Taktimpulse (C1) einer ersten Taktphase und an den Koppelpunkten der zweiten, vierten usw. Speicherzelle Taktimpulse (C2) einer zweiten Taktphase anlegbar sind, wobei sich die Taktimpulse (C1, C2) der ersten und zweiten Taktphase nicht überschneiden.

2. Schieberegister nach Anspruch 1, d a d u r c h   g e k e n n z e i c h n e t, daß die richtungsabhängigen Übertragungsglieder durch zusätzliche Emitter der über Kreuz gekoppelten Transistoren (ZT11, ZT12, ZT21, ZT22) gebildet sind.

3. Schieberegister nach Anspruch 1, d a d u r c h   g e k e n n z e i c h n e t, daß die richtungsabhängigen Übertragungsglieder durch zusätzliche, in Emitterfolgerschaltung betriebene Transistoren (ZT34, ZT35, ZT45, ZT46) gebildet sind, deren Basisanschlüsse mit den Basisanschlüssen der über Kreuz gekoppelten Transistoren der Speicherzellen verbunden sind.

4. Schieberegister nach Anspruch 1 oder 3, d a d u r c h g e k e n n z e i c h n e t , daß die über Kreuz gekoppelten Transistoren der Speicherzelle invers betrieben werden.

5. Schieberegister nach Anspruch 4, d a d u r c h g e - k e n n z e i c h n e t , daß die Lastwiderstände durch die Kollektor-Emitter-Strecken von weiteren Transistoren (ZT43, ZT44) gebildet sind, deren Leitfähigkeit zur Leitfähigkeit der über Kreuz gekoppelten Transistoren der Speicherzellen entgegengesetzt ist und deren Basisanschlüsse mit den Kollektoren der invers betriebenen, über Kreuz gekoppelten Transistoren verbunden sind.

0119388

1/2

# FIG 1

# FIG 2

2/2

0119388

FIG 3

FIG 4

FIG 5